# EUROPEAN PATENT SPECIFICATION

(11) **EP 3 431 862 B1**
(45) Date of publication and mention of the grant of the patent: **17.06.2020**
(21) Application number: 18178310.1
(22) Date of filing: 18.06.2018
(51) Int. Cl.: F21S 4/22, F21V 31/04, F21K 9/90, F21V 23/00, H05K 3/28, F21Y 103/10, F21Y 115/10

(54) **A METHOD FOR MANUFACTURING A LIGHTING DEVICE AND CORRESPONDING DEVICE**
VERFAHREN ZUR HERSTELLUNG EINER BELEUCHTUNGSVORRICHTUNG UND ENTSPRECHENDE BELEUCHTUNGSVORRICHTUNG
PROCÉDÉ DE FABRICATION D'UN DISPOSITIF D'ÉCLAIRAGE ET DISPOSITIF D'ÉCLAIRAGE CORRESPONDANT

(30) Priority: 21.07.2017 IT 201700083584
(43) Date of publication of application: 23.01.2019
(73) Proprietor: OSRAM GmbH, 80807 München (DE); OSRAM S.P.A. - SOCIETA' RIUNITE OSRAM EDISON CLERICI, 20126 Milano (IT)
(72) Inventor: BISCARO, Alessandro, I-31050 Ponzano Veneto (Treviso) (IT); DIDONE', Roberto, I-36027 Rosà (Vicenza) (IT); RIEGER, Thomas, D-93089 Aufhausen (DE); BALDO, Lorenzo, I-31040 Giavera del Montello (Treviso) (IT); REISS, Martin, D-93161 Sinzing (DE)
(74) Representative: Marchitelli, Mauro

(56) References cited:
- EP-A1- 2 846 085
- EP-A1- 2 892 078
- EP-A1- 3 263 983
- DE-A1-102008 013 454
- DE-A1-102012 222 093
- JP-A- 2000 004 075
- US-A1- 2017 205 065

## Description

### Technical field

The present description refers to lighting devices.

One or more embodiments may refer to lighting devices that use solid-state light radiation sources, such as LED sources.

One or more embodiments may concern a method for producing a lighting device.

One or more embodiments may also concern a lighting device including a strip-shaped lighting module.

### Technological background

In the field of lighting systems, the use of elongated lighting devices, for example strip-shaped, is widely used, and may comprise a printed circuit having the shape of a thin elongated strip on which a plurality of solid-state light radiation sources are fixed, for example LEDs, and a plurality of electronic components for powering and/or driving the light radiation sources.

Lighting devices of this type may comprise an encapsulation layer of cross-linked polymeric material that covers the printed circuit and the electronic components for powering and/or driving the light radiation sources.

In addition to technical requirements, such as, for example, high flexibility, ease of handling and shipping, and uniform light distribution, lighting devices can also be produced to meet aesthetic requirements. One of these aesthetic requirements may relate to the electronic components for powering and/or driving the light radiation sources. These electronic components may be dark in color, for example, black, and may appear as black dots when the lighting device is turned on, especially in the case in which the driving components are higher than the light radiation sources.

In order to make the electronic components invisible, an opaque encapsulation layer, for example, white in color, may be dispensed onto the printed circuit and the electronic components, leaving the light emission ends of the light radiation sources above the opaque encapsulation layer exposed.

This solution may be affected by some drawbacks, including:
- in order to leave only the light emission ends of the light radiation sources exposed, the electronic components should have a lower height than the light radiation sources,
- the laterally emitted light radiation would be blocked inside the opaque encapsulation layer, so that the selection of the light emission sources would be limited to greater light emission sources.

JP2000004075A discloses an electronic circuit board which can prevent ignition from power circuit components mounted on a substrate, wherein the power circuit components are mounted on a substrate and a noncombustible molding body is formed, so that the periphery of the power circuit components is completely covered and a part of the operation component is exposed.

EP2892078A1 discloses a lighting device comprising light radiation sources, drive circuitry for the light radiation source(s) (18), and a holder having a relief portion and recessed portions. The light radiation sources are mounted on the relief portion and the drive circuitry is mounted in the recessed portions. A masking material is provided to cover the drive circuitry in the recessed portions.

US2017205065A1 discloses a lighting device including a substrate with at least one electrically-powered light radiation source, and at least one sealing mass protecting the light radiation sources.

DE102012222093A1 discloses a lighting device having a conversion LED whose light-emitting surface is covered by a transparent protective cover.

EP2846085A1 discloses a lighting device comprising a mounting board with first and second opposed faces and vias extending therethrough, one or more light radiation sources mounted on the first face of the mounting board and drive circuitry mounted on the second face of the mounting board. A holder has cavities for receiving therein the drive circuitry.

EP3263983A1 is a document falling under Art. 54(3) EPC, which discloses a method of producing lighting devices including a light-permeable cover that covers the light radiation sources and leaves the associated circuitry uncovered, and a sealing mass of light-impermeable material which masks the circuitry.

### Object and summary

One or more embodiments intend to contribute to overcoming the drawbacks outlined above.

According to one or more embodiments, this object can be achieved by a method having the characteristics referred to in the following claims.

One or more embodiments may also refer to a corresponding lighting device.

The claims form an integral part of the technical disclosure provided here in relation to the invention.

One or more embodiments may concern a method for producing a lighting device in which the electronic power supply and/or driving components are covered and the emission ends of the light radiation sources are exposed, even in the case in which the electronic power supply and driving components have a greater height than the light radiation sources.

In one or more embodiments, the electronic power supply and/or driving components can be covered by an opaque curable polymeric material, which may be dispensed onto the electronic power supply and/or driving components in a selective or continuous manner.

In one or more embodiments, the electronic power supply and/or driving components may be coated with a material applied by pad printing.

In one or more embodiments, the electronic power supply and/or driving components may be covered by capsules, for example, applied by means of a pick-and-place manipulator.

One or more embodiments may offer one or more of the following advantages:
- Possibility of integrating standard encapsulation techniques or standard pad printing methods into the process flow;
- Possibility of completely covering black electronic components without affecting the emission surfaces of the light radiation sources;
- Minor limitations in the choice of light emission sources, with consequent advantages in terms of lower costs and better availability of light radiation sources;
- Greater freedom in the selection of electronic components, with consequent advantages in terms of lower costs and better availability of electronic components;
- Better aesthetic appearance.

### Brief description of the figures

One or more embodiments will be now described, purely by way of non-limiting example, with reference to the attached drawings, wherein:

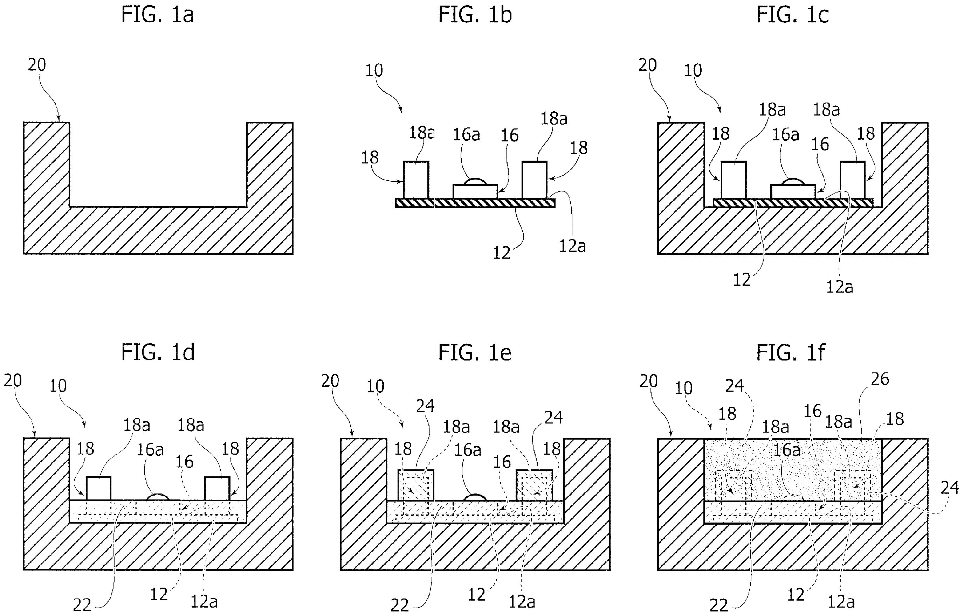

Figures 1a-1f, 2a-2f, 3a-3f, and 4a-4f are schematic views illustrating embodiments of methods for producing a lighting device.

It will be appreciated that, for clarity and simplicity of illustration, the various figures may not be reproduced on the same scale.

### Detailed description

In the following description, various specific details are illustrated aimed at a thorough understanding of examples of one or more embodiments. The embodiments can be implemented without one or more of the specific details, or with other methods, components, materials, etc. In other cases, known structures, materials or operations are not shown or described in detail to avoid obscuring various aspects of the embodiments. The reference to "an embodiment" in the context of this description indicates that a particular configuration, structure or characteristic described in relation to the embodiment is included in at least one embodiment. Therefore, phrases such as "in an embodiment", possibly present in different places of this description, do not necessarily refer to the same embodiment. Moreover, particular conformations, structures or characteristics can be combined in a suitable manner in one or more embodiments and/or associated with the embodiments in a different way from that illustrated here, so that, for example, a characteristic here exemplified in relation to a figure may be applied to one or more embodiments exemplified in a different figure.

The references used here are only for convenience and do not, therefore, define the field of protection or the scope of the embodiments.

Figures 1a-1f schematically represent an embodiment of a method for producing a strip-shaped lighting device, elongated in a longitudinal direction, perpendicular to the representation plane of the figures.

In Figure 1b, reference 10 indicates an uncoated strip-shaped lighting module. The lighting module 10 may comprise a flexible printed circuit 12 elongated in a longitudinal direction perpendicular to the representation plane of the figure. The lighting module 10 can have an indefinite length in its longitudinal direction and may be provided in the form of a reel.

The lighting module 10 may comprise a plurality of electrically-powered light radiation sources 16, which may be constituted by solid-state light radiation sources, for example, LEDs. The light radiation sources 16 may have respective light emission ends 16a. The printed circuit 12 may carry a plurality of electronic components 18 for powering and/or driving the light radiation sources 16. The light radiation sources 16 and the electronic components 18 may protrude from a first face 12a of the printed circuit 12. The light radiation sources 16 and the electronic components 18 may be fixed to the printed circuit 12 by surface-mount technology.

In one or more embodiments, the electronic components 18 may have a greater height than the light radiation sources 16, so that upper portions 18a of the electronic components 18 may protrude from the first face 12a of the printed circuit 12 by a greater height than the light emission ends 16a of the light radiation sources 16.

Figure 1a shows a channel-shaped profile 20 for receiving the lighting module 10. In one or more embodiments, the channel-shaped profile 20 may have a flexible plastic material profile. The channel-shaped profile 20 may have an indefinite length in its longitudinal direction and may be provided wound in a reel. In one or more embodiments, the channel-shaped profile 20 may form a housing of the lighting device.

As illustrated in Figure 1c, in one or more embodiments the lighting module 10 may be arranged inside the channel-shaped profile 20, with the first face 12a carrying the light radiation sources 16 and the electronic components 18 facing upwards, and with a second face opposite the first face 12a resting on a bottom wall of the channel-shaped profile 20.

In one or more embodiments, the printed circuit 12 may be fixed to the channel-shaped profile 20 by means of a layer of glue, for example, by means of a "lamination" operation.

With reference to Figure 1d, in one or more embodiments, a first opaque curable polymeric material 22 is dispensed inside the channel-shaped profile 20. In one or more embodiments, the first opaque curable polymeric material 22 covers the printed circuit 12 and leaves the light emitting ends 16a of the light radiation sources 16 and the upper portions 18a of the electronic components 18 uncovered. In one or more embodiments, the first opaque curable polymeric material 22 can be white silicone.

As illustrated in Figure 1e, the upper portions 18a of the electronic components 18 that protrude above the layer formed by the first curable polymeric material 22 may be covered with an opaque material.

In one or more embodiments, as illustrated in Figure 1e, the opaque coating of the upper portions 18a of the electronic components 18 may be obtained by dispensing a second opaque curable polymeric material 24 onto the upper portions 18a of the electronic components 18. In one or more embodiments, the second opaque polymeric material 24 may have a viscosity of more than 20,000 mPa*s. In one or more embodiments, the second curable polymeric material 24 may form a layer with a thickness ranging from 100-500 µm on the upper portions 18a of the electronic components 18. The second opaque curable polymeric material 24 may have the same color as the first opaque curable polymeric material 22.

As illustrated in Figure If, after dispensing the second opaque curable polymeric material 24, a transparent curable polymeric material 26 can be dispensed into the channel-shaped profile 20, which forms an encapsulation layer covering the lighting module 10.

In one or more embodiments, the curable polymeric materials 22, 24, 26 may be cross-linked together, for example, by continuously passing the channel-shaped profile 20 containing the lighting module 10 coated by the first, the second and the third curable polymeric material 22, 24, 26 through a heating unit.

In one or more embodiments, the second opaque curable polymeric material 22 may be selectively dispensed, so as to only cover the upper portions 18a of the electronic components 18. The selective dispensing of the second curable polymeric material 22 is schematically represented in Figure 1e. To carry out the selective dispensing of the second curable polymeric material 22, a number of dispensing nozzles may be provided, in order to cover different areas of the printed circuit 12.

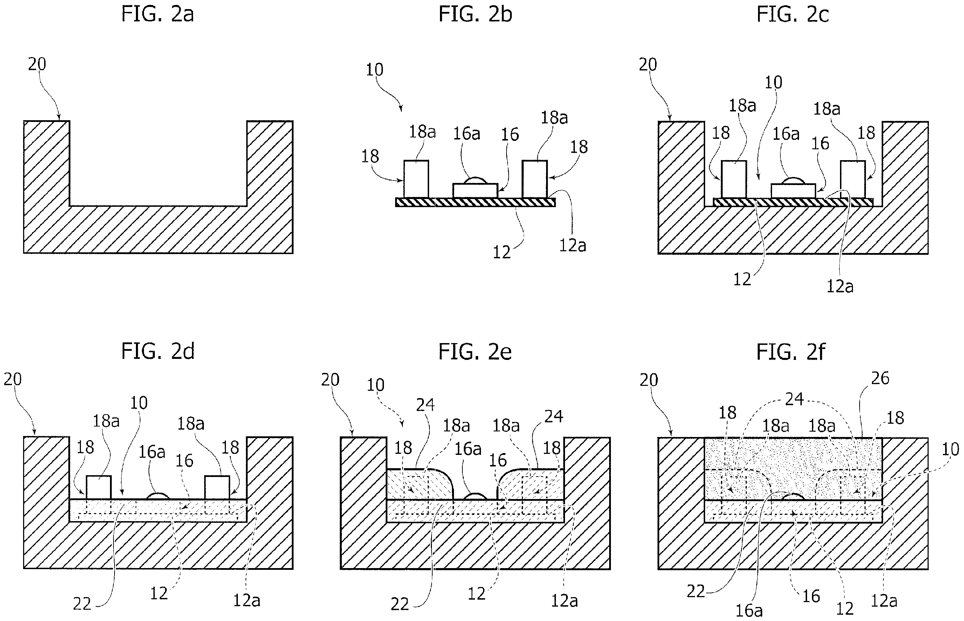

In one or more embodiments, as exemplified in the sequence of Figures 2a-2f, the second curable polymeric material 22 can be continuously dispensed to cover areas of the lighting module 10 where the electronic components 18 are applied. The continuous dispensing of the second curable polymeric material 24 is schematically represented in Figure 2e. In the variant of Figures 2a-2f, the remaining steps of the method can be the same as previously described in relation to the embodiment illustrated in Figures 1a-1f. In Figures 1a-1f and 2a-2f, the corresponding elements are indicated with the same numerical references. In the embodiment illustrated in Figures 2a-2f, the electronic components 18 may be assembled in pre-established areas of the printed circuit 12, along which the second curable polymeric material 24 is dispensed. For example, in one or more embodiments, the electronic components 18 can be assembled along the longitudinal edges of the printed circuit 12.

In one or more embodiments, the second curable polymeric material 24 may have a sufficiently high viscosity, so as not to flow above the light-emitting ends 16a of the light radiation sources 16.

In one or more embodiments, the load of white pigments contained in the second curable polymeric material 24 can be increased to about twice the load of white pigments contained in the first curable polymeric material 22 in order to obtain a better coverage of the electronic components 18.

In one or more embodiments, as exemplified in the embodiments shown in Figures 1a-1f and 2a-2f, the dispensing of the second curable polymeric material 24 can be carried out after the dispensing of the first curable polymeric material 22.

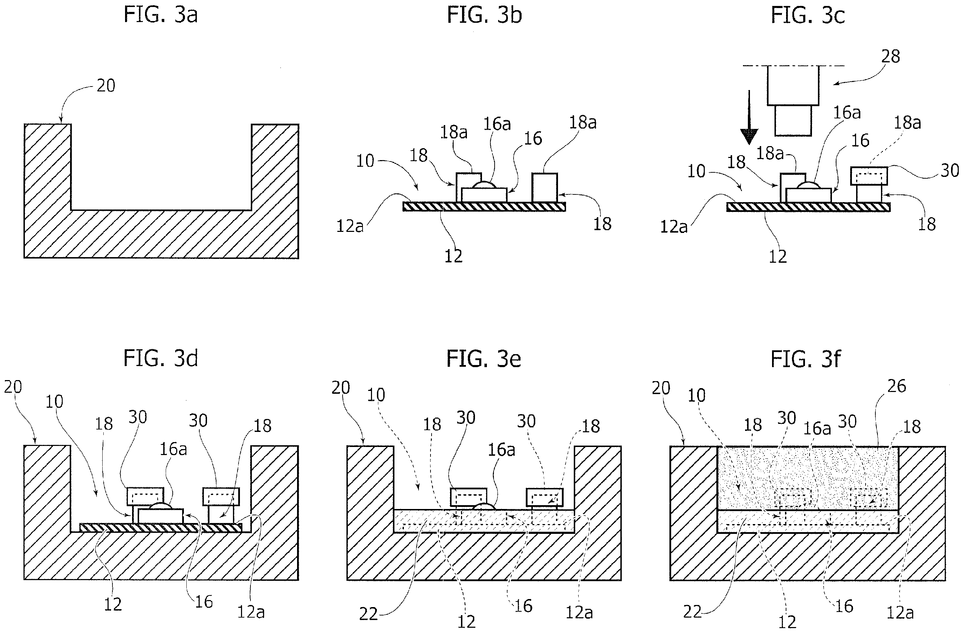

With reference to Figures 3a-3f, in one or more embodiments, coating the upper portions 18a of the electronic components 18 with an opaque material may include applying a coating of opaque material by pad printing. As illustrated in Figure 3c, a pad printing head 28 may be provided, which applies a printed coating 30 on the upper portions 18a of the electronic components 18. In one or more embodiments, the pad printing that applies the coating 30 to the electronic components 18 can be carried out on the uncoated lighting module 10 before placing the lighting module 10 inside the channel-shaped profile 20. As illustrated in Figures 3c, 3d and 3e, after the pad printing, the lighting module 10 can be positioned inside the channel-shaped profile 20 and, subsequently, the first curable polymeric material 22 can be dispensed onto the lighting module 10, leaving the light emitting ends 16a of the light radiation sources 16 uncovered and the upper portions 18a of the electronic components 18 precoated with the pad printing. In one or more embodiments, as exemplified in Figure 3f, a transparent curable polymeric material 26 can be dispensed within the channel-shaped profile 20 for sealing the lighting module 10.

The coating of the upper portions 18a of the electronic components 18 by means of pad printing allows a flexible positioning of the electronic components 18 on the printed circuit 12. The pad printing may form a coating with a thin covering layer. If necessary, a double printing step can be provided to increase the thickness of the covering layer 30. The coating layer 30, applied by means of pad printing, may have the same color as the first opaque curable polymeric material 22 (e.g. white) that covers the printed circuit 12 and the lower parts of the light radiation sources 16 and the electronic components 18.

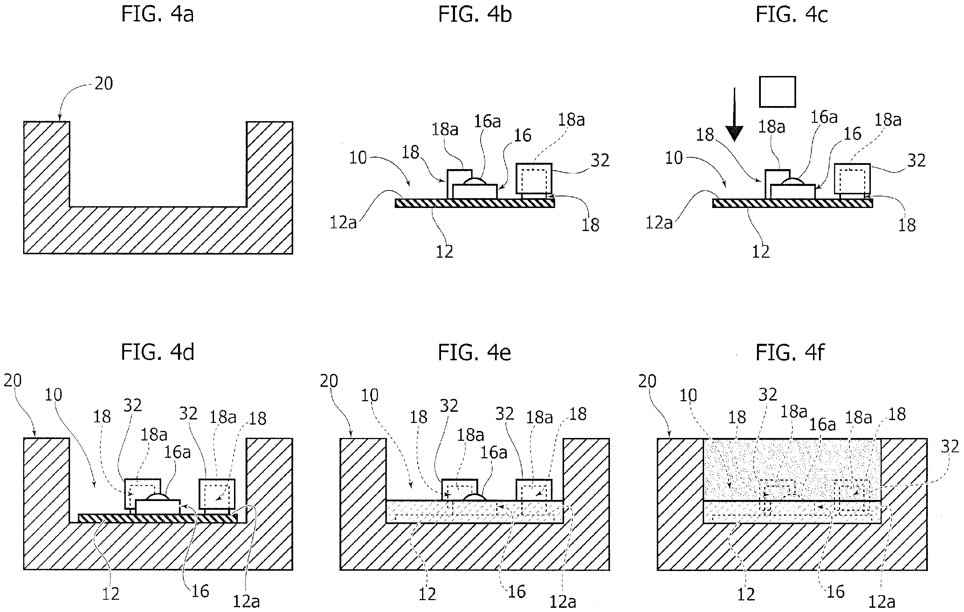

With reference to Figures 4a-4f, in one or more embodiments, coating the upper portions 18a of the electronic components 18 with an opaque material may comprise applying opaque capsules 32 onto the upper portions 18a. The opaque capsules 32 may be pre-formed plastic capsules. The capsules 32 can be assembled on the upper portions 18a of the electronic components 18 by pick-and-place manipulators. Assembly of the capsules 32 on the upper portions 18a of the electronic components 18 can be carried out on the uncoated lighting module 10, before positioning the lighting module 10 inside the channel-shaped profile 20. As exemplified in Figures 4d, 4e and 4f, the lighting module 10 comprising the capsules 32 applied to the upper portions 18a of the electronic components 18 can be arranged inside the channel-shaped profile 20 (Figure 4d) and, subsequently, the first curable polymeric material 22 can be dispensed within the channel-shaped profile 20 to cover the printed circuit 12 and the lower portions of the light radiation sources 16 and the electronic components 18 (Figure 4e). Then, a transparent curable polymeric material 26 can be dispensed into the channel-shaped profile 20 to seal the lighting module 10 (Figure 4f).

The opaque capsules 32 may have the same color as the first curable polymeric material 22 (e.g. white). The dimensions of the opaque capsules 32 may depend on the components to be coated and the tolerances of the apparatus.

One or more embodiments may, therefore, concern a method for producing a lighting device, which may comprise:
- providing a strip-shaped lighting module (e.g. 10) including a printed circuit (e.g. 12) carrying a plurality of electrically-powered light radiation sources (e.g. 16) having respective light emitting ends (e.g. 16a) and a plurality of electronic components (e.g. 18) protruding from a first face (e.g. 12a) of said printed circuit (e.g. 12), wherein said electronic components (e.g. 18) have respective upper portions (e.g. 18a) protruding from said printed circuit (e.g. 12) beyond said light emitting ends (e.g. 16a) of said electrically-powered light radiation sources (e.g. 16),
- placing said lighting module (e.g. 10) in a channel-shaped profile (e.g. 20), with said first face (e.g. 12a) of the printed circuit (e.g. 12) facing upwards,
- dispensing a first opaque curable polymeric material (e.g. 22) into said channel-shaped profile (e.g. 20), in order to cover said printed circuit (e.g. 12) and leave said light emitting ends (e.g. 16a) of said electrically-powered light radiation sources (e.g. 16) and said upper portions (e.g. 18a) of said electronic components (e.g. 18) uncovered, and
- coating said upper portions (e.g. 18a) with an opaque coating (24, 30, 32).

In one or more embodiments, coating said upper portions (e.g. 18a) of said electronic components (e.g. 18) with an opaque coating may comprise dispensing a second opaque curable polymeric material (e.g. 24) onto said upper portions (e.g. 18a) of said electronic components (e.g. 18).

One or more embodiments may comprise selectively dispensing said second opaque curable polymeric material (e.g. 24) onto said upper portions (e.g. 18a) of said electronic components (e.g. 18).

One or more embodiments may comprise continuously dispensing said second opaque curable polymeric material (e.g. 24) onto areas of said lighting module (e.g. 10) at which said electronic components are applied (e.g. 18).

In one or more embodiments, dispensing said second opaque curable polymeric material (e.g. 24) onto said upper portions (e.g. 18a) of said electronic components (e.g. 18) can be carried out after dispensing the first opaque curable polymeric material (22) into said channel-shaped profile (e.g. 20).

In one or more embodiments, said second opaque curable polymeric material (e.g. 24) may have a viscosity greater than 20,000 mPa*s.

In one or more embodiments, said second opaque curable polymeric material (e.g. 24) can form a coating with a thickness between 100-500 µm on said electronic components (e.g. 18).

In one or more embodiments, coating said upper portions (e.g. 18a) with an opaque coating may comprise applying said opaque coating (e.g. 30) to said upper portions (e.g. 18a) by pad printing.

In one or more embodiments, applying said opaque coating (e.g. 30) to said upper portions (e.g. 18a) by means of pad printing can be carried out before dispensing said first opaque curable polymeric material (e.g. 22) into said channel-shaped profile (e.g. 20).

In one or more embodiments, coating said upper portions (e.g. 18a) with an opaque coating may comprise applying opaque capsules (e.g. 32) onto said upper portions (e.g. 18a).

In one or more embodiments, applying said opaque capsules (e.g. 32) onto said upper portions (e.g. 18a) may be carried out before dispensing said first opaque curable polymeric material (e.g. 22) into said channel-shaped profile (e.g. 20).

One or more embodiments may concern a lighting device, which may comprise:
- a strip-shaped lighting module (e.g. 10) including a printed circuit (e.g. 12) carrying a plurality of electrically-powered light radiation sources (e.g. 16) having respective light emitting ends (e.g. 16a) and a plurality of electronic components (e.g. 18) protruding from a first face (e.g. 12a) of said printed circuit (e.g. 12), wherein said electronic components (e.g. 18) have respective upper portions (e.g. 18a) protruding from said printed circuit (e.g. 12) beyond said light emitting ends (e.g. 16a) of said electrically-powered light radiation sources (e.g. 16),
- a channel-shaped profile (e.g. 20) in which said strip-shaped lighting module (e.g. 10) is inserted,
- a first opaque curable polymeric material (e.g. 22) dispensed into said channel-shaped profile (e.g. 20), which covers said printed circuit (e.g. 12) and leaves said light emitting ends (e.g. 16a) of said electrically-powered light radiation sources (e.g. 16) and said upper portions (e.g. 18a) of said electronic components (e.g. 18) uncovered, and
- an opaque coating (e.g. 24, 30, 32) that coats said upper portions (e.g. 18a) of said electronic components (e.g. 18).

In one or more embodiments, said opaque coating can be formed of a second opaque curable polymeric material (e.g. 24) dispensed onto said upper portions (e.g. 18a) of said electronic components (e.g. 18).

In one or more embodiments, said opaque coating (e.g. 30) can be applied to said upper portions (e.g. 18a) by pad printing.

In one or more embodiments, said opaque coating (e.g. 30) can be formed by opaque capsules (e.g. 32) applied onto said upper portions (e.g. 18a).

Of course, without prejudice to the underlying principles of the invention, the details of construction and the embodiments may vary, even significantly, with respect to those illustrated here, purely by way of non-limiting example, without departing from the scope of the invention.

This field of protection is defined by the attached claims.

### LIST OF REFERENCE SIGNS

| | |
|---|---|
| lighting module | 10 |
| flexible printed circuit | 12 |
| electrically-powered light radiation sources | 16 |
| electronic components | 18 |
| first face | 12a |
| upper portions | 18a |
| channel-shaped profile | 20 |
| first opaque curable polymeric material | 22 |
| second opaque curable polymeric material | 24 |
| a transparent curable polymeric material | 26 |
| pad printing head | 28 |
| printed coating | 30 |
| opaque capsules | 32 |

## Claims

1. A method for producing a lighting device, comprising:
- providing a strip-shaped lighting module (10) including a printed circuit (12) carrying a plurality of electrically-powered light radiation sources (16) having respective light emitting ends (16a) and a plurality of electronic components (18) protruding from a first face (12a) of said printed circuit, wherein said electronic components (18) have respective upper portions (18a) protruding from said printed circuit (12) beyond said light emitting ends (16a) of said electrically-powered light radiation sources (16), and
- placing said lighting module (10) in a channel-shaped profile (20), with said first face (12a) of the printed circuit (12) facing upwards,
**characterized by**:
- dispensing a first opaque curable polymeric material (22) into said channel-shaped profile (20), in order to cover said printed circuit (12) and leave said light emitting ends (16a) of said electrically-powered light radiation sources (16) and said upper portions (18a) of said electronic components (18) uncovered, and
- coating said upper portions (18a) of said electronic components (18) with an opaque coating (24, 30, 32), wherein coating said upper portions (18a) of said electronic components (18) with an opaque coating comprises:
- dispensing a second opaque curable polymeric material (24) onto said upper portions (18a) of said electronic components (18), or
- applying said opaque coating (30) to said upper portions (18a) by pad printing, or
- applying opaque caps (32) onto said upper portions (18a).

2. A method according to claim 1, comprising selectively dispensing said second opaque curable polymeric material (24) onto said upper portions (18a) of said electronic components (18).

3. A method according to claim 1, comprising continuously dispensing said second opaque curable polymeric material (24) onto areas of said lighting module (10) at which said electronic components (18) are applied.

4. A method according to any of claims 1-3, wherein dispensing said second opaque curable polymeric material (24) onto said upper portions (18a) of said electronic components (18) is carried out after dispensing the first opaque curable polymeric material (22) into said channel-shaped profile (20).

5. A method according to any of claims 1-4, wherein said second opaque curable polymeric material (24) has a viscosity greater than 20,000 mPa*s.

6. A method according to any of claims 1-5, wherein said second opaque curable polymeric material (24) forms a coating on said electronic components (18), which has a thickness between 100 and 500 µm.

7. A method according to claim 1, wherein applying said opaque coating (30) to said upper portions (18a) by pad printing is carried out before dispensing said first opaque curable polymeric material (22) into said channel-shaped profile (20).

8. A method according to claim 1, wherein applying said opaque caps (32) onto said upper portions (18a) is carried out before dispensing said first opaque curable polymeric material (22) into said channel-shaped profile (20).

9. A lighting device, comprising:
- a strip-shaped lighting module (10) including a printed circuit (12) carrying a plurality of electrically-powered light radiation sources (16) having respective light emitting ends (16a) and a plurality of electronic components (18) protruding from a first face (12a) of said printed circuit (12), wherein said electronic components (18) have respective upper portions (18a) protruding from said printed circuit (12) beyond said light emitting ends (16a) of said electrically-powered light radiation sources (16),
- a channel-shaped profile (20) in which said strip-shaped lighting module (10) is inserted, **characterized by**:
- a first opaque curable polymeric material (22) dispensed into said channel-shaped profile (20), which covers said printed circuit (12) and leaves uncovered said light emitting ends (16a) of said electrically-powered light radiation sources (16) and said upper portions (18a) of said electronic components (18), and
- an opaque coating (24, 30, 32) that coats said upper portions (18a) of said electronic components (18),
wherein said opaque coating is formed by a second opaque curable polymeric material (24) dispensed onto said upper portions (18a) of said electronic components (18), or
wherein said opaque coating (30) is applied onto said upper portions (18a) by pad printing, or
wherein said opaque coating (30) is formed by opaque caps (32) applied onto said upper portions (18a) .

## Patentansprüche

1. Verfahren zum Herstellen einer Leuchtvorrichtung, das Verfahren umfassend:
- Bereitstellen eines streifenförmigen Leuchtmoduls (10) beinhaltend eine gedruckte Schaltung (12), die eine Vielzahl von elektrisch betriebenen Lichtabstrahlungsquellen (16), die jeweilige lichtausstrahlende Enden (16a) aufweisen, und eine Vielzahl von elektronischen Komponenten (18) trägt, die von einer ersten Oberfläche (12a) der gedruckten Schaltung hervorstehen, wobei die elektronischen Komponenten (18) jeweilige obere Abschnitte (18a) aufweisen, die von der gedruckten Schaltung (12) über die lichtausstrahlenden Enden (16a) der elektrisch betriebenen Lichtabstrahlungsquellen (16) hinaus hervorstehen, und
- Platzieren des Leuchtmoduls (10) in einem kanalförmigen Profil (20), wobei die erste Oberfläche (12a) der gedruckten Schaltung (12) nach oben gewandt ist,
**gekennzeichnet durch**:
- Ausgeben eines ersten undurchsichtigen härtbaren polymeren Materials (22) in das kanalförmige Profil (20) um die gedruckte Schaltung (12) zu bedecken und sowohl die lichtausstrahlenden Enden (16a) der elektrisch betriebenen Lichtabstrahlungsquellen (16) als auch die oberen Abschnitte (18a) der elektronischen Komponenten (18) unbedeckt zu lassen, und
- Beschichten der oberen Abschnitte (18a) mit einer undurchsichtigen Beschichtung (24, 30, 32), wobei Beschichten der oberen Abschnitte (18a) der elektronischen Komponenten (18) mit einer undurchsichtigen Beschichtung folgendes umfasst:
- Ausgeben eines zweiten undurchsichtigen härtbaren polymeren Materials (24) auf die oberen Abschnitte (18a) der elektronischen Komponenten (18), oder
- Aufbringen der undurchsichtigen Beschichtung (30) auf die oberen Abschnitte (18a) durch Tampondruck, oder
- Aufbringen von undurchsichtigen Kappen (32) auf die oberen Abschnitte (18a).

2. Verfahren nach Anspruch 1, umfassend selektives Ausgeben des zweiten undurchsichtigen härtbaren polymeren Materials (24) auf die oberen Abschnitte (18a) der elektronischen Komponenten (18).

3. Verfahren nach Anspruch 1, umfassend durchgehendes Ausgeben des zweiten undurchsichtigen härtbaren polymeren Materials (24) auf Bereiche des Leuchtmoduls (10), an denen die elektronischen Komponenten (18) aufgebracht sind.

4. Verfahren nach einem der Ansprüche 1-3, wobei Ausgeben des zweiten undurchsichtigen härtbaren polymeren Materials (24) auf die oberen Abschnitte (18a) der elektronischen Komponenten (18) durchgeführt wird nach Ausgeben des ersten undurchsichtigen härtbaren polymeren Materials (22) in das kanalförmige Profil (20).

5. Verfahren nach einem der Ansprüche 1-4, wobei das zweite undurchsichtige härtbare polymere Material (24) eine Viskosität aufweist, die größer ist als 20.000 mPa*s.

6. Verfahren nach einem der Ansprüche 1-5, wobei das zweite undurchsichtige härtbare polymere Material (24) eine Beschichtung auf den elektronischen Komponenten (18) bildet, die eine Dicke zwischen 100 und 500 µm aufweist.

7. Verfahren nach Anspruch 1, wobei Aufbringen der undurchsichtigen Beschichtung (30) auf die oberen Abschnitte (18a) durch Tampondruck durchgeführt wird vor Ausgeben des ersten undurchsichtigen härtbaren polymeren Materials (22) in das kanalförmige Profil (20).

8. Verfahren nach Anspruch 1, wobei Aufbringen der undurchsichtigen Kappen (32) auf die oberen Abschnitte (18a) durchgeführt wird vor Ausgeben des ersten undurchsichtigen härtbaren polymeren Materials (22) in das kanalförmige Profil (20).

9. Leuchtvorrichtung, umfassend:
- ein streifenförmiges Leuchtmodul (10) beinhaltend eine gedruckte Schaltung (12), die eine Vielzahl von elektrisch betriebenen Lichtabstrahlungsquellen (16), die jeweilige lichtausstrahlende Enden (16a) aufweisen, und eine Vielzahl von elektronischen Komponenten (18) trägt, die von einer ersten Oberfläche (12a) der gedruckten Schaltung hervorstehen, wobei die elektronischen Komponenten (18) jeweilige obere Abschnitte (18a) aufweisen, die von der gedruckten Schaltung (12) über die lichtausstrahlenden Enden (16a) der elektrisch betriebenen Lichtabstrahlungsquellen (16) hinaus hervorstehen,
- ein kanalförmiges Profil (20) in welches das streifenförmige Leuchtmodul (10) eingeführt ist,
**gekennzeichnet durch**:
- ein erstes undurchsichtiges härtbares polymeres Material (22), das in das kanalförmige Profil (20) ausgegeben ist, das die gedruckte Schaltung (12) bedeckt und sowohl die lichtausstrahlenden Enden (16a) der elektrisch betriebenen Lichtabstrahlungsquellen (16) als auch die oberen Abschnitte (18a) der elektronischen Komponenten (18) unbedeckt lässt, und
- eine undurchsichtige Beschichtung (24, 30, 32) die die oberen Abschnitte (18a) der elektronischen Komponenten (18) beschichtet,
wobei die undurchsichtige Beschichtung durch ein zweites undurchsichtiges härtbares polymeres Material (24) gebildet ist, das auf die oberen Abschnitte (18a) der elektronischen Komponenten (18) ausgegeben ist, oder
wobei die undurchsichtige Beschichtung (30) auf die oberen Abschnitte (18a) durch Tampondruck aufgebracht ist, oder
wobei die undurchsichtige Beschichtung (30) durch undurchsichtige Kappen (32) gebildet ist, die auf die oberen Abschnitte (18a) aufgebracht sind.

## Revendications

1. Un procédé de production d'un dispositif d'éclairage, comprenant :
- l'obtention d'un module d'éclairage en forme de bande (10) comprenant un circuit imprimé (12) portant une pluralité de sources de rayonnement lumineux électriquement alimentées (16) ayant des extrémités d'émission lumineuse respectives (16a), et une pluralité de composants électroniques (18) faisant saillie d'une première face (12a) dudit circuit imprimé, lesdits composants électroniques (18) ayant des parties supérieures respectives (18a) faisant saillie dudit circuit imprimé (12) au-delà desdites extrémités d'émission lumineuse (16a) desdites sources de rayonnement lumineux électriquement alimentées (16), et
- le placement dudit module d'éclairage (10) dans un profil en forme de goulotte (20), avec la première face (12a) du circuit imprimé (12) tournée vers le haut,
**caractérisé par** :
- le coulage d'un premier matériau polymère durcissable opaque (22) dans ledit profil en forme de goulotte (20), afin de recouvrir ledit circuit imprimé (12) et laisser découvertes lesdites extrémités d'émission de lumière (16a) desdites sources de rayonnement lumineux électriquement alimentées (16) et lesdites parties supérieures (18a) desdits composants électroniques (18), et
- le recouvrement desdites parties supérieures (18a) desdits composants électroniques (18) par un recouvrement opaque (24, 30, 32), le recouvrement desdites parties supérieures (18a) desdits composants électroniques (18) par un recouvrement opaque comprenant :
- le coulage d'un second matériau polymère durcissable opaque (24) par-dessus lesdites parties supérieures (18a) desdits composants électroniques (18), ou
- l'application dudit recouvrement opaque (30) sur lesdites parties supérieures (18a) par impression au tampon, ou
- l'application de couvercles opaques (32) par-dessus lesdites parties supérieures (18a).

2. Un procédé selon la revendication 1, comprenant le coulage sélectif dudit matériau polymère durcissable opaque (24) par-dessus lesdites parties supérieures (18a) desdits composants électroniques (18).

3. Un procédé selon la revendication 1, comprenant le coulage en continu dudit second matériau polymère durcissable opaque (24) par-dessus des zones dudit module d'éclairage (10) au niveau desquelles sont appliqués lesdits composants électroniques (18).

4. Un procédé selon l'une des revendications 1 à 3, dans lequel le coulage dudit second matériau polymère durcissable opaque (24) par-dessus lesdites parties supérieures (18a) desdits composants électroniques (18) est effectué après coulage du premier matériau polymère durcissable opaque (22) dans ledit profil en forme de goulotte (20).

5. Un procédé selon l'une des revendications 1 à 4, dans lequel ledit second matériau polymère durcissable opaque (24) présente une viscosité supérieure à 20 000 mPa.s.

6. Un procédé selon l'une des revendications 1 à 5, dans lequel ledit second matériau polymère durcissable opaque (24) forme sur lesdits composants électroniques (18) un recouvrement qui présente une épaisseur comprise entre 100 et 500 µm.

7. Un procédé selon la revendication 1, dans lequel l'application dudit recouvrement opaque (30) sur lesdites parties supérieures (18a) par impression au tampon est effectuée avant le coulage dudit premier matériau polymère durcissable opaque (22) dans ledit profil en forme de goulotte (20).

8. Un procédé selon la revendication 1, dans lequel l'application desdits couvercles opaques (32) par-dessus lesdites parties supérieures (18a) est effectuée avant coulage dudit premier matériau polymère durcissable opaque (22) dans ledit profil en forme de goulotte (20).

9. Un dispositif d'éclairage, comprenant :
- un module d'éclairage en forme de bande (10) comprenant un circuit imprimé (12) portant une pluralité de sources de rayonnement lumineux électriquement alimentées (16) ayant des extrémités d'émission lumineuse respectives (16a), et une pluralité de composants électroniques (18) faisant saillie d'une première face (12a) dudit circuit imprimé, lesdits composants électroniques (18) ayant des parties supérieures respectives (18a) faisant saillie dudit circuit imprimé (12) au-delà desdites extrémités d'émission lumineuse (16a) desdites sources de rayonnement lumineux électriquement alimentées (16) ,
- un profil en forme de goulotte (20) dans lequel est inséré ledit module d'éclairage en forme de bande (10) ,
**caractérisé par** :
- un premier matériau polymère durcissable opaque (22) coulé dans ledit profil en forme de goulotte (20), qui recouvre ledit circuit imprimé (12) et laisse découvertes lesdites extrémités d'émission de lumière (16a) desdites sources de rayonnement lumineux électriquement alimentées (16) et lesdites parties supérieures (18a) desdits composants électroniques (18), et
- un recouvrement opaque (24, 30, 32) qui recouvre lesdites parties supérieures (18a) desdits composants électroniques (18),
dans lequel ledit recouvrement opaque est formé par un second matériau polymère durcissable opaque (24) coulé par-dessus lesdites parties supérieures (18a) desdits composants électroniques (18), ou
dans lequel ledit recouvrement opaque (30) est appliqué par-dessus lesdites parties supérieures (18a) par impression au tampon, ou
dans lequel ledit recouvrement opaque (30) est formé par des couvercles opaques (32) appliqués par-dessus lesdites parties supérieures (18a).
